# EUROPEAN PATENT APPLICATION

(11) **EP 4 554 093 A1**
(43) Date of publication of application: **14.05.2025**
(21) Application number: 23208320.4
(22) Date of filing: 07.11.2023
(51) Int. Cl.: H03K 17/16, H02M 1/00, H02M 1/08

(54) **GATE DRIVING CIRCUIT FOR A VOLTAGE CONTROLLED POWER SEMICONDUCTOR SWITCH TO CONTROL DV/DT AND METHOD OF OPERATING A POWER SEMICONDUCTOR SWITCH**

(71) Applicant: Silicon Austria Labs GmbH, 8010 Graz (AT)
(72) Inventor: AUINGER, Bernhard, 8020 Graz (AT); VOLLMAIER, Franz, 8453 St. Johann i. S. (AT); BERGER, Hubert, 8642 St. Lorenzen im Mürztal (AT); KRENN, Johann, 8020 Graz (AT)
(74) Representative: Wirnsberger & Lerchbaum Patentanwälte OG

(57) **Abstract**

The invention concerns a gate driving circuit (1) for a voltage controlled power semiconductor switch (2) to control dv/dt, wherein the gate driving circuit (1) comprises a gate connection (3) for connection to a gate of the power semiconductor switch (2), a turn-on connection (4), and a turn-off connection (5) to apply a turn-on voltage (Vₚₒₛ) to the gate connection (3) via the turn-on connection (4) and to apply a turn-off voltage (V_{neg}) to the gate connection (3) via the turn-off connection (5). To achieve a high application practicability for dv/dt control the turn-on connection (4) is connected to the gate connection via a turn-on resistor stage (6) and the turn-off connection (5) is connected to the gate connection via a turn-off resistor stage (7), wherein the turn-on resistor stage (6) and/or the turn-off resistor stage (7) each comprises one, preferably a plurality of, activatable and/or deactivatable setting resistors (R_{on,n}).

Furthermore, the invention concerns a method of operating a power semiconductor switch (2).

## Description

The invention concerns a gate driving circuit for a voltage controlled power semiconductor switch to control dv/dt, wherein the gate driving circuit comprises a gate connection for connection to a gate of the power semiconductor switch, a turn-on connection, and a turn-off connection to apply a turn-on voltage to the gate connection via the turn-on connection and to apply a turn-off voltage to the gate connection via the turn-off connection.

Furthermore, the invention concerns a method of operating a power semiconductor switch, wherein a gate of the power semiconductor switch is connected to a gate driving circuit for controlling the power semiconductor switch.

Furthermore, the invention concerns a use of a gate driving circuit or a method of operating a power semiconductor switch.

When controlling a power semiconductor switch with a gate driving circuit, a dv/dt (voltage change over time) of an output signal of the power semiconductor switch is usually an important control parameter. This applies in particular to applications with high-frequency switching operations, for example when operating an electric motor with several power semiconductor switches arranged in the form of half bridges, which are usually operated in a pulse-width modulated manner. Often electromechanical components, especially inductors or electric motors, are sensitive to high dv/dt values, so usually an attempt is made to reduce the dv/dt of the output signals of the power semiconductor switches. The dv/dt is usually set such that voltage overshoots and voltage ringing are reduced. The respective power semiconductor switch can be implemented, for example, in the form of an IGBT (insulated-gate bipolar transistor) or MOSFET (metal-oxide-semiconductor field-effect transistor).

For setting the dv/dt, different implementations of gate driving circuits are known, each of which usually has different disadvantages. For example, a gate resistor with a constant resistance can be used to set a certain slope of the voltage response. However, an increase in gate resistance is usually associated with greater switching losses and often a limitation of the maximum switching frequency. Also known are active gate drive circuits, which are often implemented with an active voltage measurement of the output signal of the power semiconductor switch and a feedback loop to set a gate voltage. However, these can usually be used at low switching speeds of power semiconductor switches and usually require a complex implementation with a high number of components. In particular, the control of power semiconductor switches, for example SiC transistors or GaN transistors, which are usually operated at high switching speeds, often proves to be complex regarding dv/dt control.

It is an object of the invention to provide a gate driving circuit which provides high application practicability for dv/dt control.

A further object of the invention is to provide a method of operating a power semiconductor switch, which provides high application practicability for dv/dt control.

Further, it is an object of the invention to provide a use of a gate driving circuit and/or a method of operating a power semiconductor switch, which enables high application practicability for dv/dt control.

To achieve the foregoing objects, the invention provides a gate driving circuit for a voltage controlled power semiconductor switch to control dv/dt, wherein the gate driving circuit comprises a gate connection for connection to a gate of the power semiconductor switch, a turn-on connection, and a turn-off connection to apply a turn-on voltage to the gate connection via the turn-on connection and to apply a turn-off voltage to the gate connection via the turn-off connection, wherein the turn-on connection is connected to the gate connection via a turn-on resistor stage and the turn-off connection is connected to the gate connection via a turn-off resistor stage, wherein the turn-on resistor stage and/or the turn-off resistor stage each comprises one, preferably a plurality of, activatable and/or deactivatable setting resistors.

The basis of the invention is the idea of implementing the gate driving circuit such that during operation of the gate driving circuit, in which the gate connection of the gate driving circuit is connected to a gate of a power semiconductor switch for control of the power semiconductor switch, a gate resistance for switching, in particular switching on and switching off, of the power semiconductor switch can be set in a controlled manner. This can be achieved if the turn-on connection is connected to the gate connection via a turn-on resistor stage and the turn-off connection is connected to the gate connection via a turn-off resistor stage, wherein the turn-on resistor stage has one, preferably a plurality, of activatable and/or deactivatable setting resistors and the turn-off resistor stage has one, preferably a plurality, of activatable and/or deactivatable setting resistors. With activating and/or deactivating the setting resistors of the turn-on resistor stage, a resistance between the turn-on connection of the gate driving circuit and the gate connection can be varied. With activating and/or deactivating the setting resistors of the turn-off resistor stage, a resistance between the turn-off connection of the gate driving circuit and the gate connection can be varied. Thus, a gate resistance and/or the dv/dt (voltage change over time) of an output signal of the power semiconductor switch can be varied, especially during an operation of the gate driving circuit and/or power semiconductor switch. Usually, the setting resistors of the turn-on resistor stage are called turn-on resistors and the setting resistors of the turn-off resistor stage are called turn-off resistors. Usually, the respective setting resistor can be activated in a controlled, particularly regulated, manner and/or deactivated in a controlled, particularly regulated, manner. Typically, the respective setting resistor of the turn-on resistor stage is connected between the turn-on connection and the gate connection. Typically, the respective setting resistor of the turn-off resistor stage is connected between the turn-off connection and the gate connection.

The turn-on connection of the gate driving circuit can be connected to the gate connection via a main turn-on resistor of the gate driving circuit, which main turn-on resistor is connected in parallel to the setting resistor, in particular to the turn-on resistors, of the turn-on resistor stage. The turn-off connection of the gate driving circuit can be connected to the gate connection via a main turn-off resistor of the gate driving circuit, which is connected in parallel to the setting resistor, in particular to the setting resistors, of the turn-off resistor stage. In this way, the gate resistor can be formed with the main turn-on resistor and/or main turn-off resistor when the setting resistors of the turn-on resistor stage and/or turn-off resistor stage are deactivated. The gate resistor may represent, especially in operation, an effective resistor formed for applying a voltage to the gate connection or to a gate of the power semiconductor switch connected to the gate connection with the gate driving circuit. The gate resistor may be formed with the main on-resistor, the main off-resistor, and the setting resistors. A high gate resistor is usually related to a small dv/dt. A low gate resistor is usually related to a large dv/dt. The main turn-on resistor may be part of the turn-on resistor stage. The main turn-off resistor can be part of the turn-off resistor stage.

Operation, in particular of the gate driving circuit, refers to a state in which a power semiconductor switch is controlled by the gate driving circuit. For this, the gate connection of the gate driving circuit is usually connected to a gate of the power semiconductor switch for controlling the power semiconductor switch. The power semiconductor switch can be controlled, particularly regulated, with the gate driving circuit such that a dv/dt of an output signal of the power semiconductor switch is varied, in particular during operation.

The turn-on resistor stage and the turn-off resistor stage can each comprise a plurality of resistor branches connected in parallel to one another, wherein the respective resistor branch comprises, connected in series, a setting resistor and a setting switch in order to activate or deactivate the setting resistor by switching the setting switch. Typically, the respective resistor branch of the turn-on resistor stage is connected between the turn-on connection and the gate connection. Usually, the respective resistor branch of the turn-off resistor stage is connected between the turn-off connection and the gate connection. In this way, a magnitude of the dv/dt of the output signal of the power semiconductor switch can be varied in a controlled manner during operation with a change of an effective total resistance formed by the setting resistors.

In operation, when switching the turn-on resistors and/or the power semiconductor switch, instabilities may occur as a result of a negative feedback of an internal drain-gate capacitance of the power semiconductor switch, in particular referred to as Miller effect. This can be mitigated if the gate driving circuit has a capacitor to increase the gate-source capacitance, especially at high gate resistance. However, such a capacitor is usually associated with gate losses and a reduction of a dv/dt range due to charging and discharging of the capacitor during switching operations. The gate driving circuit may comprise a capacitor bank connected to the gate connection, wherein the capacitor bank comprises one or a plurality of capacitor bank capacitors that can be activated in a controlled manner and/or deactivated in a controlled manner to vary a capacitance of the capacitor bank. In this way, instabilities can be mitigated while achieving low gate losses and/or a wide dv/dt range. In particular, the respective setting resistors and the respective capacitor bank capacitors can be activated and/or deactivated in a coordinated controlled manner to set, in particular control, a dv/dt of the output signal of the power semiconductor switch. For example, a large dv/dt of the output signal can be set if a low gate resistance is set with the on-resistance stage and/or the off-resistance stage and a low capacitance value, in particular a low gate-source capacitance, is set with the capacitor bank.

The gate driving circuit typically comprises a bias voltage connection, wherein the capacitor bank, in particular the respective capacitor bank capacitor, is connected to the bias voltage connection to apply a bias voltage to the capacitor bank, in particular the respective capacitor bank capacitor, via the bias voltage connection. The bias voltage connection may be connected to a bias voltage terminal to which the bias voltage is applied during operation, typically in the form of a bias potential. The capacitor bank, in particular the respective capacitor bank capacitor, is usually connected between the bias voltage connection and the gate connection. In operation, the bias voltage may be selected such that a high capacitance of the capacitor bank is present when the power semiconductor switch is switched and/or when a threshold voltage of the power semiconductor switch is applied between the gate and source of the power semiconductor switch. The bias voltage may be substantially equal to the threshold voltage of the power semiconductor switch, especially during operation. The capacitor bank may comprise a plurality of capacitor branches connected in parallel to each other, wherein the respective capacitor branch comprises a capacitor bank capacitor and a capacitor branch switch which are connected in series in order to activate or deactivate the respective capacitor bank capacitor by switching the respective capacitor branch switch. Typically, the respective capacitor branch, in particular the respective capacitor bank capacitor and/or capacitor branch switch, is connected between the bias voltage connection and the gate connection.

The respective capacitor bank capacitor may exhibit a nonlinear capacitance-voltage characteristic. The capacitance of the capacitor bank capacitor is then usually nonlinearly dependent on the voltage applied to the capacitor bank capacitor. The respective capacitor bank capacitor may be nonlinear capacitor bank capacitors. The respective capacitor bank capacitor may be a ceramic capacitor, in particular a class 2 or class 3 ceramic capacitor, especially formed with X7R or X7S according to EIA RS-198 classification. The capacitance-voltage characteristic of the respective capacitor bank capacitor may exhibit a capacitance maximum. In operation, the capacitor bank capacitors can be biased with the bias voltage such that when the power semiconductor switch is switched and/or when a threshold voltage is applied between gate and source of the power semiconductor switch, a large capacitance value, in particular a maximum capacitance, of the capacitor bank capacitors is present. Preferably, the respective capacitor bank capacitor can be biased during operation via the bias voltage connection with a bias voltage substantially equal to a threshold voltage of the power semiconductor switch. In particular, this way it is achievable that a high capacitance, in particular maximum capacitance, of the capacitor bank, in particular of the respective capacitor bank capacitor, and/or the source-drain capacitance of the power semiconductor switch is present when a threshold voltage is present at the power semiconductor switch, in particular at the gate and source, for switching the power semiconductor switch, and a small capacitance is present when a voltage deviating from the threshold voltage is present.

The gate driving circuit can comprise a drive stage. The drive stage is usually designed to apply a turn-on voltage to the turn-on voltage and the turn-on connection and a turn-off voltage to the turn-off connection, in particular in a controlled manner, preferably in a regulated manner. For controlling the drive stage, the drive stage may comprise a driver. The drive stage can comprise a turn-on switch and a turn-off switch, wherein the turn-on switch is connected to the turn-on connection for switching a turn-on voltage to the turn-on connection and the turn-off switch is connected to the turn-off connection for switching a turn-off voltage to the turn-off connection. The turn-on switch and the turn-off switch can be connected in the form of a half bridge, in particular to form a push-pull amplifier stage. With switching of the turn-on switch, a turn-on voltage can be applied to the turn-on connection and with switching of the turn-off switch, a turn-off voltage can be applied to the turn-off connection. The turn-on switch may comprise a control input for controlling the turn-on switch. The turn-off switch may comprise a control input for controlling the turn-off switch. To control the turn-on switch and the turn-off switch, the control inputs of the turn-on switch and the turn-off switch may be connected to the driver, typically via a drive switch resistor. The turn-on connection may be connected to a turn-on voltage terminal, particularly via the turn-on switch. The turn-off connection may be connected to a turn-off voltage terminal, in particular via a turn-off switch. The turn-on voltage terminal and/or the turn-off voltage terminal are usually part of the gate driving circuit, in particular the drive stage. The application of the turn-on voltage via the turn-on connection can be implemented with a turn-on potential connected to the turn-on voltage connection in operation. The application of the turn-off voltage via the turn-off connection can be implemented with a turn-off potential connected to the turn-off connection terminal in operation. Typically, the turn-on switch is connected to the turn-on voltage terminal. Typically, the turn-off switch is connected to the turn-off voltage terminal. The driver is usually an isolated driver, which forms an isolation barrier. The turn-on switch and/or the turn-off switch is in each case usually a transistor, in particular a bipolar transistor or MOSFET. The respective control input of the turn-on switch and/or turn-off switch is usually a base of the bipolar transistor or a gate of the MOSFET.

The gate driving circuit may comprise a steering device, wherein the steering device is connected to the turn-on resistor stage and/or the turn-off resistor stage and/or the capacitor bank in order to apply control signals to these with the steering device for activating and/or deactivating the setting resistors and/or the capacitor bank capacitors. The steering device can be designed for, in particular controlled, preferably regulated, generation and/or forwarding of the control signals. For this, the steering device can be connected via control paths to the setting switches and/or capacitor branch switches for transmitting control signals in order to control switching of the setting switches and/or capacitor branch switches with the control signals. Usually, the setting switches and/or capacitor branch switches can be controlled, particularly switched, separately from each other. The respective setting switch and/or capacitor branch switch can be connected to the setting device via its own control path in order to control the respective setting switch or capacitor branch switch via the respective control path. The steering device can be designed with a, especially as, microcontroller and/or IO expander.

The setting switch of the respective resistor branch can each be connected to a level shifter of the gate driving circuit, wherein the level shifter is designed to apply a boost voltage to a control input of the setting switch for controlling the setting switch by switching a level shifter switch of the level shifter. The respective setting switch is usually a setting transistor, in particular a MOSFET. The control input of the setting switch is then usually a gate of the setting transistor, particularly of the MOSFET. The capacitor branch switch of the respective capacitor branch can be connected in each case to a level shifter of the gate driving circuit, the level shifter being designed to apply a boost voltage to a control input of the capacitor branch switch with switching of a level shifter switch of the level shifter in order to control the capacitor branch switch. The respective capacitor branch switch is usually a capacitor branch transistor, in particular a MOSFET. The control input of the capacitor branch switch is then usually a gate of the capacitor branch transistor, particularly of the MOSFET. The level shifter can be designed to switch the boost voltage or a secondary voltage to the control input of the setting switch or capacitor branch switch to control the respective setting switch or capacitor branch switch with switching of the level shifter switch. The boost voltage is usually beyond an upper and lower limit of a gate source signal of the power semiconductor switch, especially during operation. Usually, the boost voltage is larger than the turn-on voltage. The secondary voltage, which is usually smaller than the boost voltage, may be equal to or smaller than the turn-off voltage. The respective resistor branch and/or respective capacitor branch is usually assigned its own level shifter.

The gate of the respective setting transistor and/or capacitor branch transistor can be connected to a control path in order to apply a voltage, in particular a boost voltage, to the gate via the control path for controlling the respective transistor. A resistor branch capacitor and/or capacitor branch capacitor can be connected between the gate and a source of the respective transistor and the control path can comprise a control path resistor which is connected in series to the gate of the respective transistor and to the resistor branch capacitor or accordingly capacitor branch capacitor. A low-pass filter can be formed with the control path resistor and the resistor branch capacitor or accordingly capacitor branch capacitor. This applies particularly to the respective resistor branch and/or respective capacitor branch. In this way, control of the setting transistor and/or capacitor branch transistor with high stability can be achieved. Depending on a capacitance of the respective resistance branch capacitor or capacitor branch capacitor and a resistance of the respective control path resistor, a speed of a transition from one dv/dt value to another dv/dt value can be set. Usually, the respective control path is connected to one of the level shifters to apply the boost voltage to the respective setting transistor or capacitor branch transistor with the respective level shifter. To protect the setting transistor and/or capacitor branch transistor, a diode, in particular a Zener diode, can be connected in parallel with the resistance branch capacitor and/or capacitor branch capacitor between the gate and source of the respective transistor. The respective resistor branch capacitor and/or capacitor branch capacitor and/or the diode and/or the control path is usually part of the respective turn-on resistor stage or turn-off resistor stage or capacitor bank, particularly of the respective resistor branch or capacitor branch.

The gate driving circuit may comprise an IO expander, wherein the IO expander is connected to the turn-on resistor stage and/or the turn-off resistor stage and/or the capacitor bank to control the activation and/or deactivation of the setting resistors and/or the capacitor bank capacitors with control signals transferred via the IO expander. The gate driving circuit may comprise a bus isolator for forming an isolation barrier of the gate driving circuit and a serial bus connected to the bus isolator for transmitting control signals transferred via the bus isolator with the serial bus for activating and/or deactivating the setting resistors and/or the capacitor bank capacitors. The bus isolator may be connected to the IO expander via the serial bus to transfer the control signals. The IO expander may be connected to the respective level-shifter for controlling the level-shifters, in particular the level-shifter switches of the level-shifters, to control the activation and/or deactivation of the setting resistors and/or the capacitor bank capacitors. Thus, the level-shifters can be controlled with control signals transferred via the bus isolator. In this way, the gate driving circuit can be implemented with a small number of data lines. In particular, control data can be efficiently transferred across the isolation barrier formed with the bus isolator. The bus isolator may have a bus isolator interface for transferring control signals through the isolation barrier formed with the bus isolator to the serial bus.

A power semiconductor switch circuit may be provided, wherein the power semiconductor switch circuit comprises a power semiconductor switch and a gate driving circuit, wherein a gate connection of the gate driving circuit is connected to the gate of the power semiconductor switch for controlling the power semiconductor switch. The gate driving circuit may be implemented as described in this document. The power semiconductor switch circuit may have a plurality of power semiconductor switches and a plurality of gate driving circuits, wherein the power semiconductor switches are each connected to one of the gate driving circuits for controlling the power semiconductor switches. Typically, a gate connection of the respective gate driving circuit is connected to a gate of the respective power semiconductor switch. The power semiconductor switches can each be assigned their own gate driving circuit. The power semiconductor switch circuit may comprise a control board, wherein the respective gate driving circuit is connected to the control board to control the gate driving circuits with the control board. The respective gate driving circuit can be connected to the control board via a control line, in particular its own control line, for transmitting control signals. The control board may be connected to the bus isolator, in particular the bus isolator interface, of the respective gate driving circuit in order to transfer control signals to the bus isolator to control the gate driving circuit. The control board may be connected to a ground potential.

A control circuit comprising a power semiconductor switch circuit, in particular as described in this document, and an electromechanical component may be provided, wherein the power semiconductor switch circuit is connected to the electromechanical component for driving the electromechanical component. For this, the power semiconductor switch, in particular the power semiconductor switches, of the power semiconductor switch circuit can be connected to the electromechanical component to operate the electromechanical component. The electromechanical component can be an inductor or electric motor.

The power semiconductor switch can be a transistor, in particular an IGBT (insulated-gate bipolar transistor) or a MOSFET (metal-oxide-semiconductor field-effect transistor). Especially, the power semiconductor switch can be implemented as a SiC transistor or GaN transistor.

An inverter, in particular for operating an electromechanical component, especially an electric motor, may be provided, wherein the inverter comprises a plurality of power semiconductor switches, wherein the respective power semiconductor switch is connected respectively to a gate driving circuit of the inverter for controlling the power semiconductor switch. The semiconductors switches can be arranged in the form of half bridges. The half bridges may be connected in parallel to one another or may be connected non-parallel to one another. The gate driving circuit may be implemented as described in this document. The power semiconductor switches and gate driving circuits may represent a power semiconductor switch circuit as described, in particular, above in this document and the inverter may be implemented according to the features of the power semiconductor switch circuit. The inverter can be implemented with different inverter topologies. For example the inverter may comprise a plurality of phase connections for connection to phase terminals of the electromechanical component, especially electric motor. Each two of the half bridges may be connected to one of the phase connections via coupled inductors to combine the output signals of the two half bridges into a total output signal. Usually the half bridges are then connected in in parallel to one another. Alternatively or cumulatively, the inverter may be implemented with a B6 bridge type inverter topology, a T-type inverter topology, a NPC inverter topology, or a multilevel inverter topology. The inverter and the electromechanical component, especially electric motor, may form an inverter circuit, wherein the inverter is connected to the electromechanical component, especially electric motor, to operate the electromechanical component, particularly as described in this document. The inverter can be an aforementioned control circuit or be designed accordingly.

Furthermore, the invention concerns a method of operating a power semiconductor switch, wherein a gate of the power semiconductor switch is connected to a gate driving circuit for controlling the power semiconductor switch, which gate driving circuit is implemented as described in this document, wherein with controlled activation or deactivation of one or a plurality of setting resistors of the turn-on resistor stage and/or of the turn-off resistor stage and/or in particular of one or a plurality of capacitor bank capacitors of the capacitor bank, a dv/dt of an output signal of the power semiconductor switch is changed in a controlled manner. The method of operating a power semiconductor switch can be designed analogously to the features and effects described in this document in the context of a gate driving circuit. The same applies analogously to the gate driving circuit with respect to the method of operating a power semiconductor switch. The method of operating a power semiconductor switch may also be referred to as a method of operating a gate driving circuit.

Furthermore, the invention concerns a use of a gate driving circuit, in particular a gate driving circuit as described in this document, or a method for operating a power semiconductor switch, in particular as described in this document, wherein the gate driving circuit or the method of operating is used to test or operate a motor, especially electric motor, or an inductor or a filter, in particular a grid filter. Usually, a power semiconductor switch is controlled with the gate driving circuit to change a dv/dt of an output signal of the power semiconductor switch in a controlled manner, particularly regulated, manner. The motor or the inductor or the filter, especially the grid filter, can be supplied with the output signal of the power semiconductor switch.

The skilled person understands that the voltages and resistances described in this document are usually electrical quantities. A connection of electrical or electronic components described in this document usually refers to an electrical connection, in particular for the transmission of an electrical quantity, in particular an electrical voltage and/or an electrical current. The dv/dt control usually refers to a control of a dv/dt of an output signal of a power semiconductor switch, which is controlled with the gate driving circuit. Usually dv refers to a voltage change of the output signal of the power semiconductor switch and dt to a time change. An activation of the respective setting resistor usually refers to a connection of the setting resistor to the gate connection, and a deactivation of the resistor usually refers to a disconnection of the resistor from the gate connection. This applies in an analogous manner to an activation and deactivation of the respective capacitor bank capacitor.

The invention will now be described by way of example with reference to the accompanying drawings, in which:
Fig. 1 shows a schematic diagram of a power semiconductor switch circuit, comprising a power semiconductor switch and a gate driving circuit;
Fig. 2 shows a schematic diagram of a further power semiconductor switch circuit, comprising a power semiconductor switch and a gate driving circuit;
Fig. 3 shows a graph with output signals of a power semiconductor switch of a power semiconductor switch circuit according to Fig. 2;
Fig. 4 shows a schematic of an inverter for operating a motor.

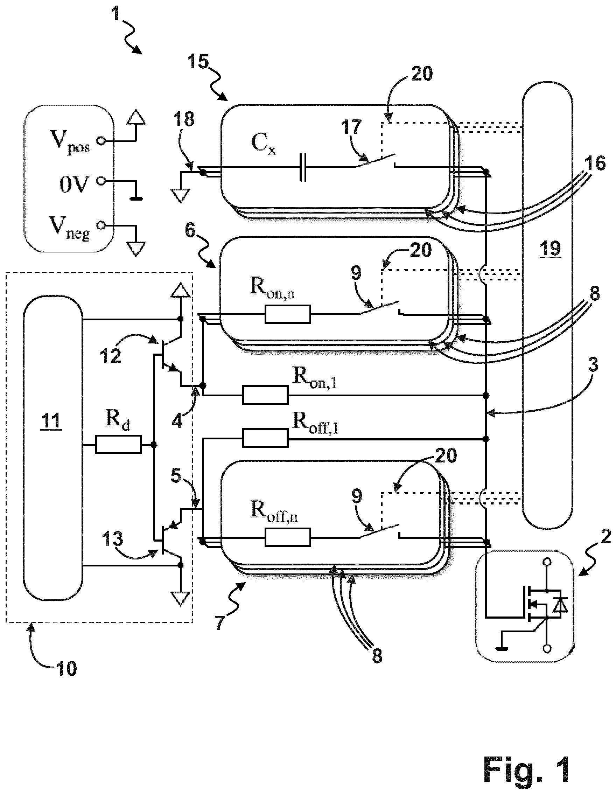

In Fig. 1, a schematic diagram of a power semiconductor switch circuit is shown, wherein the power semiconductor switch 2 circuit comprises a power semiconductor switch 2 and a gate driving circuit 1. A gate connection 3 of the gate driving circuit 1 is connected to the gate of the power semiconductor switch 2 for controlling the power semiconductor switch 2. The gate driving circuit 1 comprises a turn-on connection 4 and a turn-off connection 5, wherein the turn-on connection 4 is connected to the gate connection 3 via a turn-on resistor stage 6 and the turn-off connection 5 is connected to the gate connection 3 via a turn-off resistor stage 7. The turn-on resistor stage 6 and/or the turn-off resistor stage 7 each comprises a plurality of resistor branches 8 connected in parallel to one another, wherein the respective resistor branch 8 comprises, connected in series, a setting resistor R_{on,n} and a setting switch 9 to activate or deactivate the setting resistor R_{on,n}, in particular in a controlled, preferably regulated manner, by switching the setting switch 9. The turn-on connection 4 of the gate driving circuit 1 is connected to the gate connection 3 via a main turn-on resistor R_{on,1} of the gate driving circuit 1, which main turn-on resistor R_{on,1} is connected in parallel to the resistor branches 8, particularly to the setting resistors R_{on,n}, of the turn-on resistor stage 6. The turn-off connection 5 of the gate driving circuit 1 is connected to the gate connection 3 via a main turn-off resistor R_{off,1} of the gate driving circuit 1, which is connected in parallel to the resistor branches 8, particularly to the setting resistors R_{on,n}, of the turn-off resistor stage 7. By activating and/or deactivating setting resistors R_{on,n} of the turn-on resistor stage 6 and/or turn-off resistor stage 7, a gate resistance and/or the dv/dt of an output signal of the power semiconductor switch 2 can be varied, particularly during operation of the power semiconductor switch 2. The gate driving circuit 1 comprises a drive stage 10 including an isolated driver 11, a turn-on switch 12 and a turn-off switch 13. The turn-on switch 12 is connected to the turn-on connection 4 for switching a turn-on voltage Vₚₒₛ to the turn-on connection 4, and the turn-off switch 13 is connected to the turn-off connection 5 for switching a turn-off voltage V_{neg} to the turn-off connection 5. The turn-on switch 12 and/or the turn-off switch 13 can be part of the isolated driver 11. The turn-on switch 12 and turn-off switch 13 are connected in the form of a half bridge and usually form a push-pull amplifier stage. A control terminal of the turn-on switch 12 and a control terminal of the turn-off switch 13 are connected to the driver 11 for controlling the turn-on switch 12 and turn-off switch 13 via a drive switch resistor Rd.

The gate driving circuit 1 comprises a plurality of capacitor branches 16 connected in parallel with one another, wherein the respective capacitor branch 16 comprises a capacitor bank capacitor Cx and a capacitor branch switch 17 connected in series to activate or deactivate the capacitor bank 15 capacitor, particularly in a controlled, preferably regulated manner, by switching the capacitor branch switch 17. The respective capacitor branch 16 is connected between a bias voltage connection 18 of the gate driving circuit 1 and the gate connection 3. Via the bias voltage connection 18, the respective capacitor bank capacitor Cx can be biased with a bias voltage. The respective setting resistors R_{on,n} and the respective capacitor bank capacitors Cx can be activated and/or deactivated in a controlled manner, in particular in coordination with each other, to set, in particular to control, a dv/dt to of the output signal of the power semiconductor switch 2.

Preferably, the respective capacitor bank capacitor Cx exhibits a nonlinear capacitance voltage characteristic with a capacitance maximum. The respective capacitor bank capacitor Cx may be biased with the bias voltage such that a maximum capacitance of the capacitor bank capacitors Cx is present when the power semiconductor switch 2 is switched and/or when a treshold voltage Vₜₕ of the power semiconductor switch 2 is applied between gate and source of the power semiconductor switch 2. This is usually achievable if the bias voltage is selected to be substantially equal to a threshold voltage Vₜₕ of the power semiconductor switch 2.

The gate driving circuit 1 can comprise a steering device, wherein the steering device is connected to the turn-on resistor stage 6 and/or the turn-off resistor stage 7 and/or the capacitor bank 15 in order to control the activation and/or deactivation of the setting resistors R_{on,n} and/or the capacitor bank capacitors Cx with control signals from the steering device. For example, the steering device can be implemented as an IO expander 19 in order to control the activation and/or deactivation of the setting resistors R_{on,n} and/or the capacitor bank capacitors Cx with control signals transmitted via the IO expander 19. For this purpose, the IO expander 19 can be connected via control paths 20 to the setting switches 9 and/or capacitor branch switches 17 for transmitting control signals to control switching of the setting switches 9 and/or capacitor branch switches 17 with the control signals. Alternatively, the steering device can be designed as a microcontroller.

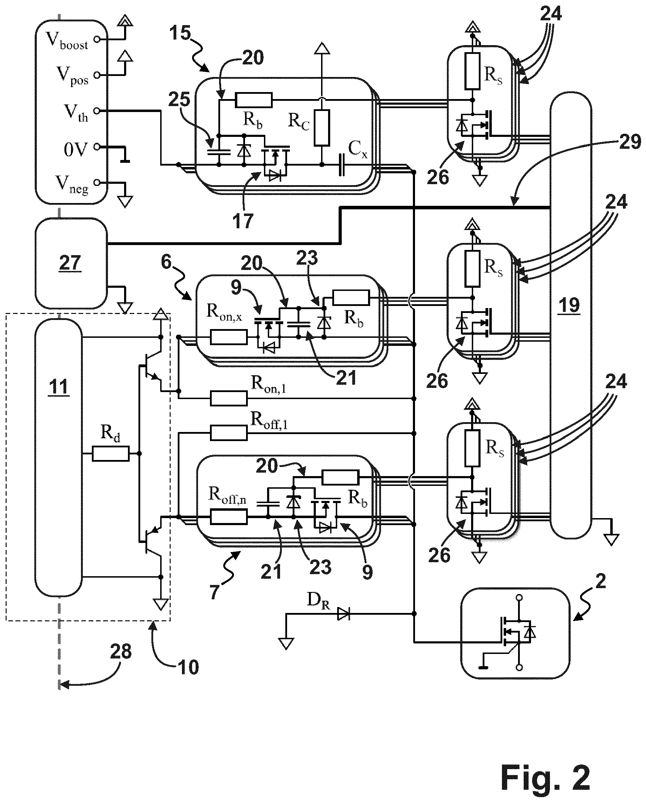

Fig. 2 shows a schematic diagram of a further power semiconductor switch circuit, wherein the power semiconductor switch circuit comprises a power semiconductor switch 2 and a gate driving circuit 1. The power semiconductor switch circuit can be implemented according to the features of the power semiconductor switch circuit described with respect to Fig. 1, in particular with corresponding features. The setting switches 9 and capacitor branch switches 17 can each be implemented as MOSFETs, in particular n-MOSFETs. In the respective resistor branch 8 of the turn-on resistor stage 6 and turn-off resistor stage 7, a gate of the respective setting switch 9 is connected in each case to a control path 20 of the resistor branch in order to apply a voltage, in particular a boost voltage V_{boost}, to the gate via the control path 20 for controlling the respective setting switch 9 or capacitor branch switch 17. Between the gate and a source of the setting switch 9 a resistor branch capacitor 21 is connected and the control path 20 comprises a control path resistor R_{b} which is connected in series to the gate of the setting switch 9 and to the resistor branch capacitor 21. To protect the setting switch 9, a diode 23, in particular a Zener diode, can be connected in parallel with the resistor branch capacitor 21 between the gate and source of the setting switch 9. In the respective capacitor branch 16 of the capacitor bank 15, a gate of the respective capacitor branch switch 17 is connected in each case to a control path 20 of the capacitor branch 16 in order to apply a voltage, in particular a boost voltage V_{boost}, to the gate via the control path 20 for controlling the respective capacitor branch switch 17. A capacitor branch capacitor 25 is connected between the gate and a source of the capacitor branch switch 17, and the control path 20 comprises a control path resistor R_{b} which is connected in series with the gate of the capacitor branch switch 17 and the capacitor branch capacitor 25. A diode 23, in particular a Zener diode, can be connected in parallel with the capacitor branch capacitor between the gate and the source of the capacitor branch switch 17 to protect the capacitor branch switch 17.

The control path 20 of the respective resistor branch 8 and the respective capacitor branch 16 is connected in each case to a level shifter 24 of the gate driving circuit 1, wherein the level shifter 24 is designed to apply a boost voltage V_{boost} to a control input of the setting switch 9 for controlling the setting switch 9 by switching a level shifter switch 26 of the level shifter 24. For this purpose, the level shifter 24 may comprise a level shifter branch comprising, connected in series in the order indicated, a boost voltage terminal for connecting a boost voltage V_{boost}, a level shifter resistor Rs, the level shifter switch 26, and a secondary voltage terminal for connecting a secondary voltage which may correspond to the turn-off voltage V_{neg}. The respective control path 20 is connected to the level shifter branch between the level shifter resistor R_{S} and the level shifter switch 26. The IO expander 19 is connected to the respective level shifter switch 26 to control the level shifters 24. The gate driving circuit 1 may comprise a bus isolator 27 and a serial bus 29 connected to the bus isolator 27, wherein the serial bus 29 is connected to the IO expander 19 to transmit control signals which are transferred via the bus isolator 27 with the serial bus 29 for activating and/or deactivating the setting resistors R_{on,n} and/or the capacitor bank capacitors Cx. The isolated driver 11 and/or bus isolator 27 can form an isolation barrier 28 of the gate driving circuit 1.

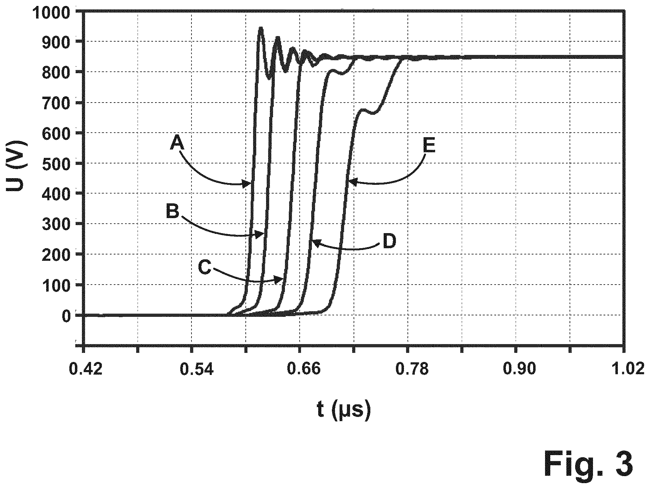

Fig. 3 shows a graph with output signals A, B, C, D, E of the power semiconductor switch of the power semiconductor switch circuit according to Fig. 2, wherein the respective output signal is represented as electric voltage U in volts over time t in µs. The output signals A, B, C, D, E correspond to different combinations of respectively activated or deactivated setting switches and respectively activated or deactivated capacitor bank capacitors. The output signal A corresponds to a condition in which all setting resistors are activated and all capacitor bank capacitors are deactivated. This results in a high dv/dt value of the output signal. The output signal E corresponds to a state in which all setting resistors are deactivated and all capacitor bank capacitors are activated. This results in a low dv/dt value of the output signal. The output signals B, C, D correspond exemplarily to different states in which parts of the setting resistors are activated and deactivated and parts of the capacitor bank capacitors are activated and deactivated.

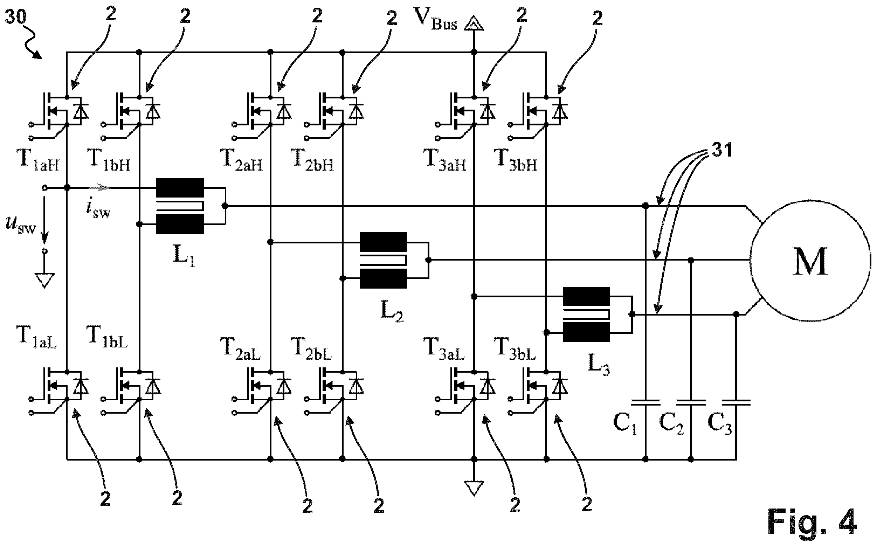

Fig. 4 shows a schematic diagram of an inverter 30 for operating a motor M, especially electric motor. The inverter 30 comprises six half bridges connected in parallel to each other, wherein the respective half bridge is formed with two semiconductor power switches 2 which are connected in series. The respective power semiconductor switch 2 is each connected to a gate driving circuit 1 of the inverter 30 for controlling the power semiconductor switch 2. This may be implemented as described with respect to Fig. 1 and Fig. 2. The inverter 30 may comprise a plurality of phase connections 31 for connection to phase terminals of a motor M, wherein each two of the half bridges are connected to one of the phase connections 31 via coupled inductors L1, L2, L3 to combine the output signals of the respective two half bridges into an overall output signal.

## Claims

1. Gate driving circuit (1) for a voltage controlled power semiconductor switch (2) to control dv/dt, wherein the gate driving circuit (1) comprises a gate connection (3) for connection to a gate of the power semiconductor switch (2), a turn-on connection (4), and a turn-off connection (5) to apply a turn-on voltage (Vₚₒₛ) to the gate connection (3) via the turn-on connection (4) and to apply a turn-off voltage (V_{neg}) to the gate connection (3) via the turn-off connection (5), **characterized in that** the turn-on connection (4) is connected to the gate connection via a turn-on resistor stage (6) and the turn-off connection (5) is connected to the gate connection via a turn-off resistor stage (7), wherein the turn-on resistor stage (6) and/or the turn-off resistor stage (7) each comprises one, preferably a plurality of, activatable and/or deactivatable setting resistors (R_{on,n}).

2. Gate driving circuit (1) according to claim 1, wherein the turn-on resistor stage (6) and the turn-off resistor stage (7) each comprise a plurality of resistor branches (8) connected in parallel with one another, wherein the respective resistor branch (8) comprises, connected in series, a setting resistor (R_{on,n}) and a setting switch (9) in order to activate or deactivate the setting resistor (R_{on,n}) by switching the setting switch (9).

3. Gate driving circuit (1) according to claim 1 or 2, wherein the gate driving circuit (1) comprises a capacitor bank (15) connected to the gate connection (3), wherein the capacitor bank (15) comprises one or a plurality of capacitor bank capacitors (Cx) that can be activated or deactivated in a controlled manner to vary a capacitance of the capacitor bank (15).

4. Gate driving circuit (1) according to claim 3, wherein the capacitor bank (15) comprises a plurality of capacitor branches (16) connected in parallel to each other, wherein the respective capacitor branch (16) comprises a capacitor bank capacitor (Cx) and a capacitor branch switch (17) which are connected in series in order to activate or deactivate the respective capacitor bank (15) capacitor by switching the respective capacitor branch switch (17).

5. Gate driving circuit (1) according to claim 3 or 4, wherein the respective capacitor bank capacitor (Cx) exhibits a nonlinear capacitance-voltage characteristic.

6. Gate driving circuit (1) according to any one of claims 3 to 5, wherein the capacitance-voltage characteristic of the respective capacitor bank capacitor (Cx) of the capacitor bank (15) exhibits a capacitance maximum, wherein preferably the respective capacitor bank capacitor (Cx) can be biased via a bias voltage connection (18) of the capacitor bank (15) with a bias voltage substantially equal to a threshold voltage (Vₜₕ) of the power semiconductor switch (2).

7. Gate driving circuit (1) according to any one of claims 1 to 6, wherein the gate driving circuit (1) comprises a drive stage (10) which comprises a turn-on switch (12) and a turn-off switch (13), wherein the turn-on switch (12) is connected to the turn-on connection (4) for switching the turn-on voltage (Vₚₒₛ) to the turn-on connection (4) and the turn-off switch (13) is connected to the turn-off connection (5) for switching the turn-off voltage (V_{neg}) to the turn-off connection (5).

8. Gate driving circuit (1) according to any one of claims 2 to 7, wherein the setting switch (9) of the respective resistor branch (8) is connected to a level shifter (24) of the gate driving circuit (1), wherein the level shifter (24) is designed to apply a boost voltage (V_{boost}) to the setting switch (9) for controlling the setting switch (9) by switching a level shifter switch (26) of the level shifter (24).

9. Gate driving circuit (1) according to claim 8, wherein the gate driving circuit (1) comprises a bus isolator (27) to form an isolation barrier (28), a serial bus (29) and an IO expander (19), wherein the bus isolator (27) is connected to the IO expander (19) via the serial bus (29), wherein the respective level shifter (24) is connected to the IO expander (19) to control the level shifters (24) with control signals via the bus isolator (27).

10. Gate driving circuit (1) according to any one of claims 2 to 9, wherein in the respective resistor branch (8), the setting switch (9) is a setting transistor, wherein the gate of the setting transistor is connected to a control path (20) for applying a boost voltage (V_{boost}) to the gate of the setting transistor to switch the setting transistor, wherein a resistor branch capacitor (21) of the resistor branch (8) is connected between the control path (20) and a source of the setting transistor, and wherein the control path (20) comprises a control path resistor (22) connected in series with the gate of the setting transistor and with the resistor branch capacitor (21).

11. Power semiconductor switch circuit comprising a power semiconductor switch (2) and a gate driving circuit (1), wherein a gate connection (3) of the gate driving circuit (1) is connected to the gate of the power semiconductor switch (2) for controlling the power semiconductor switch (2), **characterized in that** the gate driving circuit (1) is designed according to one of claims 1 to 10.

12. Inverter (30), in particular for operating an electromechanical component, especially an electric motor (M), wherein the inverter (30) comprises a plurality of power semiconductor switches (2), wherein the respective power semiconductor switch (2) is connected respectively to a gate driving circuit (1) of the inverter (30) for controlling the power semiconductor switch (2), **characterized in that** the respective gate driving circuit (1) is designed according to one of claims 1 to 10.

13. Inverter (30) according to claim 12, wherein the power semiconductor switches (2) are arranged in the form of half bridges connected in parallel to one another, wherein the inverter (30) comprises a plurality of phase connections (31) for connection to phase terminals of the electromechanical component, wherein each two of the half bridges are connected to one of the phase connections (31) via coupled inductors (32) to combine the output signals of the two half bridges into a total output signal.

14. Method of operating a power semiconductor switch (2), wherein a gate of the power semiconductor switch (2) is connected to a gate driving circuit (1) for controlling the power semiconductor switch (2), **characterized in that** the gate driving circuit (1) is a gate driving circuit (1) according to according to one of claims 1 to 10, wherein with controlled activation or deactivation of one or a plurality of setting resistors (R_{on,n}) of the turn-on resistor stage (6) and/or of the turn-off resistor stage (7) and/or in particular of one or a plurality of capacitor bank capacitors (Cx) of the capacitor bank (15), a dv/dt of an output signal of the power semiconductor switch (2) is changed in a controlled manner.

15. Use of a gate driving circuit (1) according to any one of claims 1 to 10 or a method according to claim 14 to test or operate a motor (M) or an inductor or a filter, in particular a grid filter, wherein a power semiconductor switch (2) is controlled with the gate driving circuit (1) to change a dv/dt of an output signal of the power semiconductor switch (2) in a controlled manner, particularly regulated, manner.
